# EUROPEAN PATENT SPECIFICATION

(11) **EP 1 181 849 B1**
(45) Date of publication and mention of the grant of the patent: **20.11.2002**
(21) Application number: 00920660.8
(22) Date of filing: 05.04.2000
(51) Int. Cl.: H05K 5/02, B42D 15/10

(54) **PLUG-IN CARD FOR ELECTRONIC EQUIPMENT**
STECKKARTE FÜR ELEKTRONISCHE GERÄTE
CARTE ENFICHABLE POUR EQUIPEMENT ELECTRONIQUE

(30) Priority: 02.06.1999 DE 19925146
(43) Date of publication of application: 27.02.2002
(73) Proprietor: ITT MANUFACTURING ENTERPRISES, INC., Wilmington, Delaware 19801 (US)
(72) Inventor: SCHREMMER, Andreas, 73614 Schorndorf (DE)
(74) Representative: Dreiss, Fuhlendorf, Steimle & Becker
(86) International application number: PCT/EP00/03006
(87) International publication number: WO 00/076282

(56) References cited:
- EP-A- 0 743 717
- DE-A- 19 815 549
- US-A- 5 563 400
- US-A- 5 752 857

## Description

This invention relates to a plug-in card for electronic equipment according to the preamble of Claim 1.

Such plug-in cards are used, for example, as PC cards conforming to the "Personal Computer Memory Card Industry Association" (PCMCIA) standards in portable computers (laptops, notebooks), in which, by means of a chip card, such as a SIM card, for example, the user's identification is required in order to use or access a service. Such services can be credit cards, online services or the mobile telephone network, for example.

For such plug-in cards that are provided with a receptacle for a chip card, the necessarily low overall height of the PC card of around 5 mm, for example, has to be taken into account; furthermore, for the replacement of the chip card (SIM card) the PC card should remain sealed and the screening retained as before. Moreover, the stability of the PC card should not be adversely affected and the insertion and removal of the chip card should be achieved as simply as possible. Finally, this should involve the smallest possible number of components.

A plug-in card is known in which the receptacle for the chip card is a separate component that can be inserted into the plug-in card, for example, and into whose hinged cover the chip card is plugged (ITT Corporation, 1995 brochure "CCM plug connectors for chip cards"). In this known receptacle, on the one hand the overall height is problematical and on the other hand there are problems with regard to the screening of the plastic cover.

In a further known plug-in card, the receptacle is designed in such a way that the chip card is slid in from the end or from a side (US-A-5 563 400) of the plug-in card. This type of end or side receptacle for the chip card in the plug-in card affects the stability of the plug-in card, since a cut-out is provided at the end or a side which is basically responsible for the stiffness. In most cases, such a receptacle therefore requires a frameless plug-in card, as otherwise the supporting frames have to be interrupted.

In the prior German patent applications 198 15 549.2 and 198 46 366.9 an access opening for the chip card has been proposed in one of the two housing parts of the metal housing of the plug-in card, a frame for guiding the chip card relative to the contact-making arrangement is provided, which is retained on the printed circuit board and is a separate component or a constituent part of the contact-making arrangement. This requires space on the printed circuit board, which goes against the desire for a higher printed circuit board packing density.

The object of this invention is therefore to create a plug-in card for electronic equipment, of the type mentioned at the outset, whose chip card receptacle adversely affects neither the overall height nor the stability of the plug-in card and, furthermore, leads to a reduction in the space requirement and the number of components.

In order achieve this object, in the case of a plug-in card for electronic equipment of the type mentioned at the outset, the features stated in Claim 1 are provided.

Due to the measures according to the invention, the chip card receptacle can be used not only for frameless plug-in cards but also for plug-in cards with stiffening frames, without adversely affecting the stability of the plug-in card and without considerably impairing the screening. Furthermore, the space otherwise required on the printed circuit board is reduced, since lateral guide elements are not formed by components on the printed circuit board, which otherwise have no function. The provision of guide elements as part of the corresponding housing part has no effect whatsoever on the dense packing on the printed circuit board, which also applies when components already needed on the printed circuit board are used for guiding the chip card.

According to the features of Claim 2, the opening in the relevant housing part can be constructed in the form of a trough with an access slot. A configuration which is less restrictive to the packing arrangement on the printed circuit board, and is therefore more advantageous, is produced by the features of Claim 3, according to which the access for the chip card requires less vertical space.

Simple production of the recess and the ramp, respectively, is ensured with the features of Claim 4 and the features of Claim 5. The features of Claim 6 are provided in order to obtain the access slot. The features of Claim 7 or 8 and in conjunction with them, optionally those of Claim 9 and/or Claim 10 or the features of Claim 11 and/or Claim 12, are provided in a further development of the lateral guide elements. This avoids any needless space requirement on the printed circuit board for the chip card guidance.

Depending on the measures to be taken for the ejection, the chip card can be located partially or completely between the relevant housing part and the printed circuit board or its contact-making arrangement, respectively. In order to limit this insertion accordingly, a stop is provided according to the features of Claim 13. According to the features of Claims 14, 15 and 16, respectively, this insertion limit stop can, as is the case of the chip card guide elements, be formed by suitable measures on the relevant housing part or by a printed circuit board component that is already being used. Ejection is to be achieved either by frictional contact between one of the user's fingers and the external area of one side of the chip card or by introducing a pointed object into the ejection slot according to the feature of Claim 17.

Further particulars of the invention are to be found in the following description in which the invention is described and explained in further detail with the aid of exemplary embodiments illustrated in the drawing, of which:
- Figure 1: shows a perspective representation of a plug-in card for electronic equipment according to a first exemplary embodiment of this invention;
- Figure 2: shows an enlarged, partial representation of the plug-in card of Figure 1, without the upper housing part;
- Figure 3: shows an enlarged, partial representation of the upper housing part of the plug-in card of Figure 1, viewed from above;
- Figure 4: shows the upper housing part of Figure 3, but viewed from below;
- Figure 5: shows a partial representation, viewed from above, of the upper housing part of a plug-in card for electronic equipment according to a second exemplary embodiment of this invention;
- Figure 6: shows the representation of the plug-in card according to the second exemplary embodiment, with the upper housing part removed, and
- Figure 7: shows a representation corresponding to Figure 6, with chip card placed into position by the upper housing part.

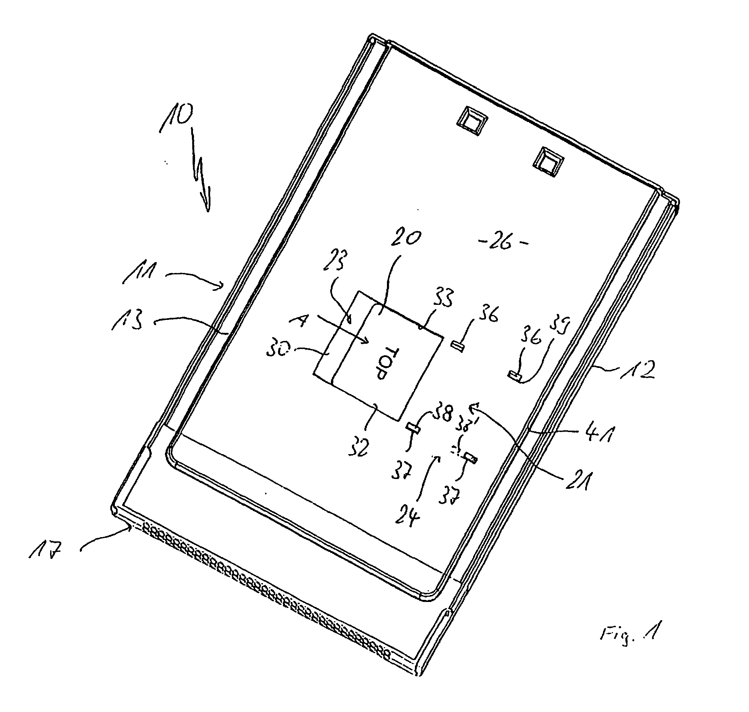

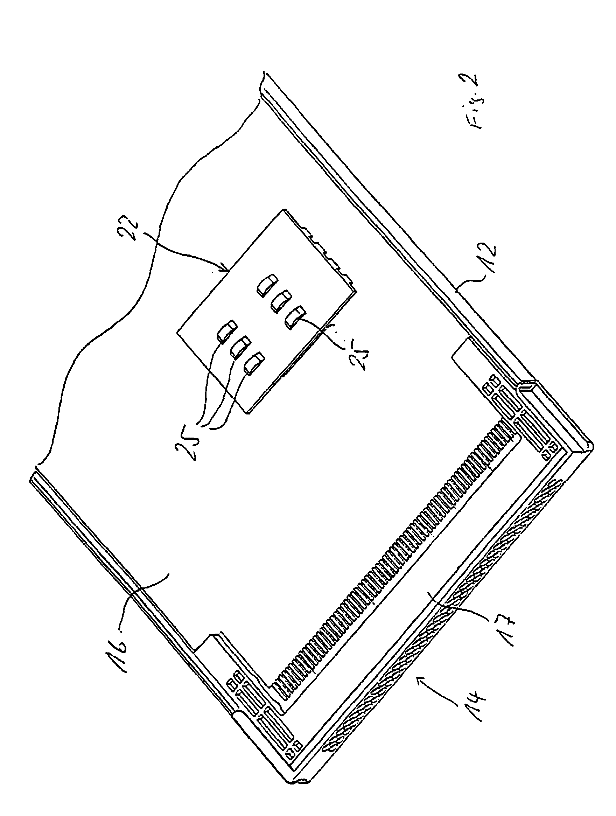

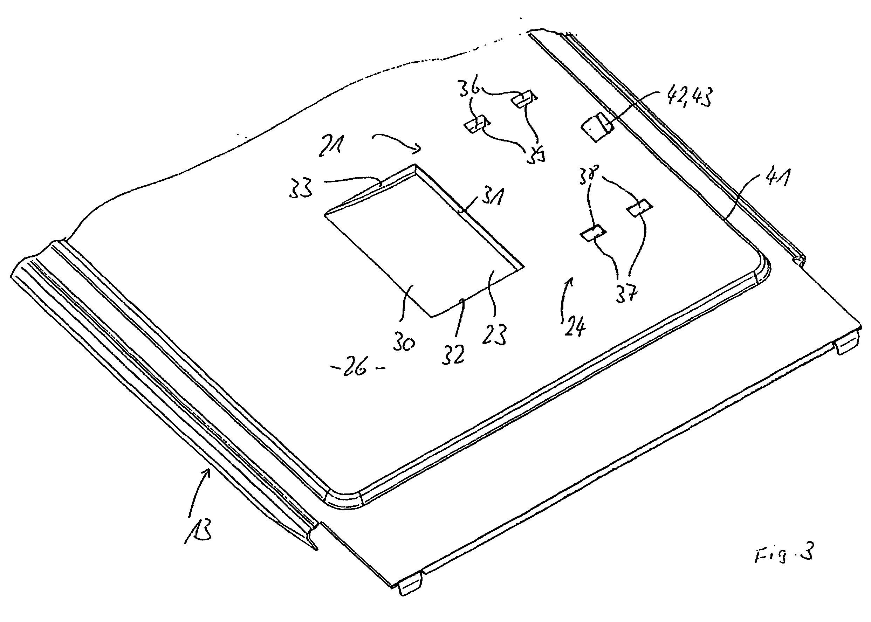

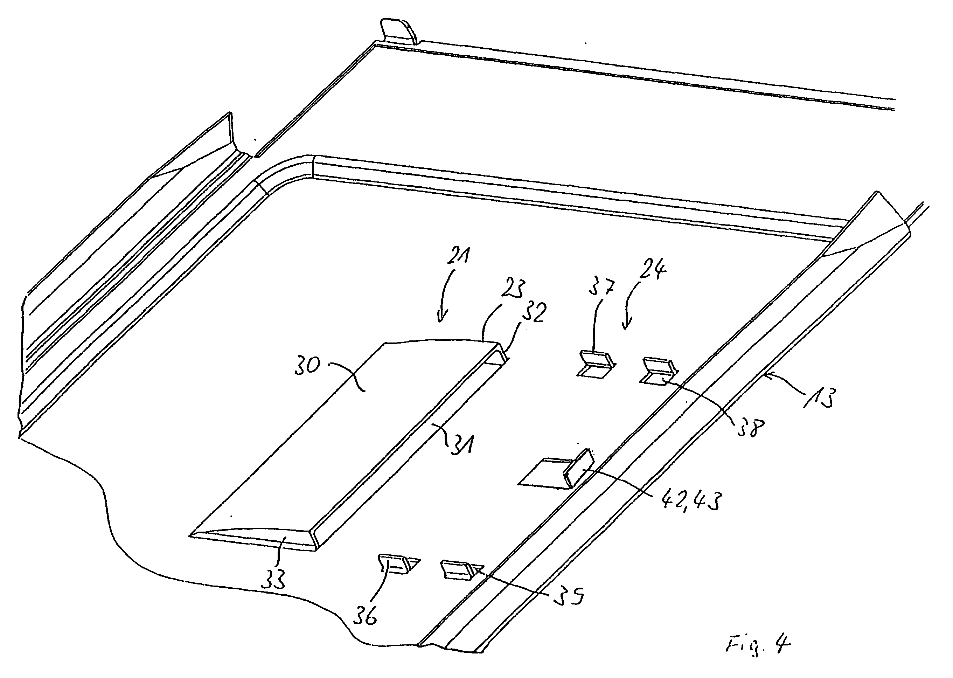

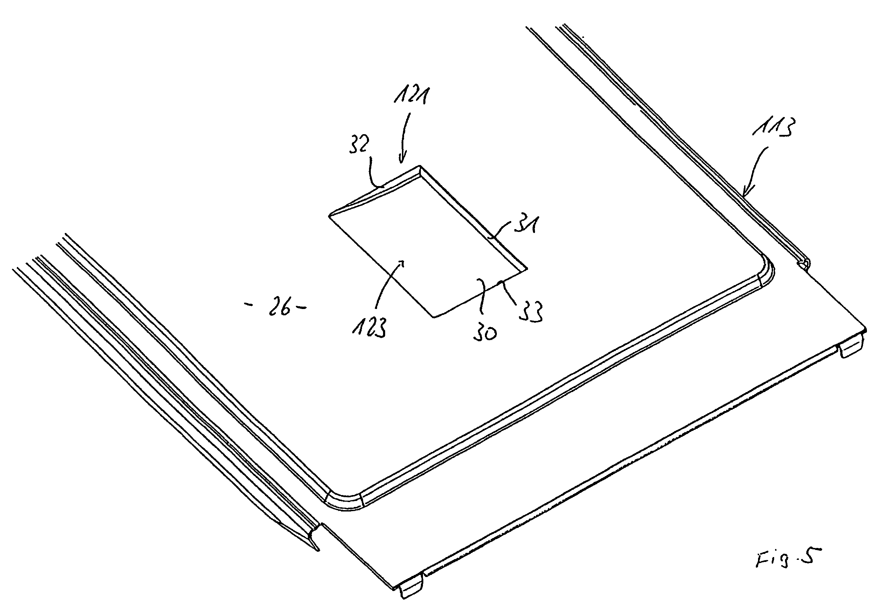

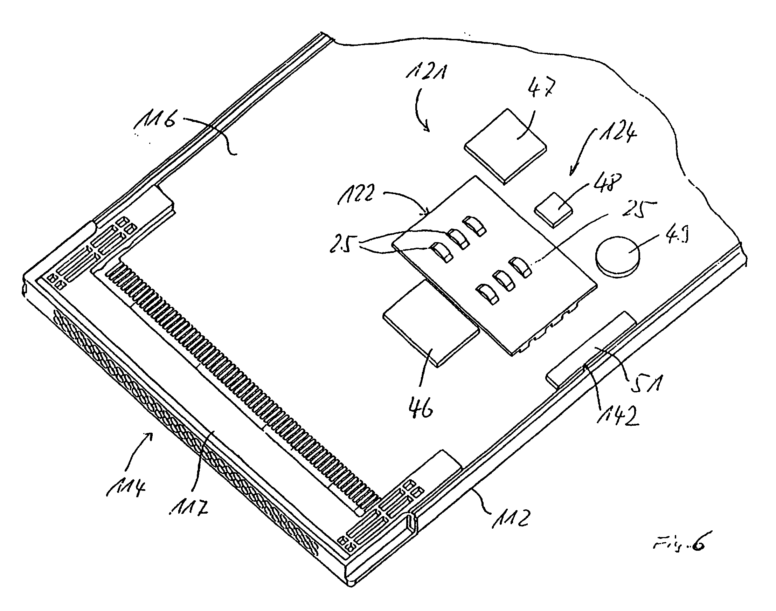

As shown in Figure 1 and according to the exemplary embodiments of Figures 1 to 4 and 5 to 7, the plug-in card 10, designed for use in electronic equipment, has an elongated, rectangular and very flat frameless housing 11 that is composed of a lower metallic housing part 12 and an upper metallic housing part 13 and 113, respectively, that can be joined or is joined to said lower metallic housing part at the longitudinal edge in a locking manner. A unit 14 and 114, respectively, which includes a printed circuit board 16 and 116, respectively, fitted with electronic components, and an edge connector 17, 117 arranged at at least one transverse end of the printed circuit board 16, 116 and connected to said printed circuit board, is arranged and held in place between the two housing parts 12 and 13 and 113, respectively. Furthermore, the plug-in card 10 has a device 21 and 121, respectively, to accept and hold a chip card 20, in the form of a SIM card, for example, as used in plug-in cards designed as PC cards in portable computers (laptops, notebooks) conforming to the "Personal Computer Memory Card Industry Association (PCMCIA)" standards.

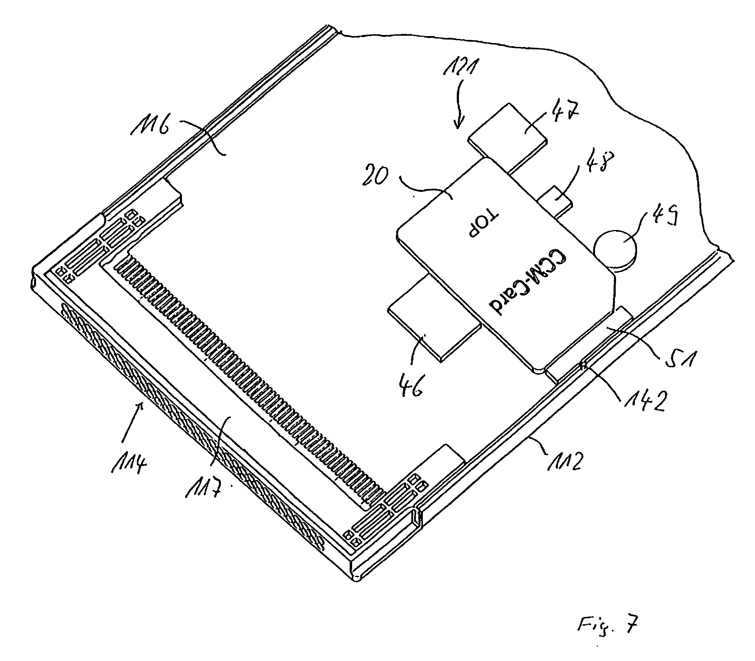

According to the exemplary embodiment of Figures 1 to 4, the chip card receiving device 21 has an opening unit 23 in the upper housing part 13, and a guide unit 24 that is likewise provided at the upper housing part 13. In the region of the opening unit 23 and guide unit 24 provided in the upper housing part 13, a contact-making arrangement 22 is provided on the printed circuit board 16 and attached to the latter. Figure 2 shows the position of the contact-making arrangement 22 on the printed circuit board 16, the other electrical or electronic components with which the printed circuit board 16 is directly packed or loaded, not being shown. The contact-making arrangement 22 has, among other things, contacts 25 on which the chip card 20, not shown, rests with its contact areas in an electrically contacting manner when in the inserted position.

The opening unit 23 has a ramp 30 that is pressed into the upper housing part 13 from its upper side 26 by deep drawing, for example. The ramp 30, which is inclined inwards towards the printed circuit board 16, opens out into a slot 31 that is delimited by said ramp and by the adjacent area of the upper housing part 13. The side edges parallel to the chip card insertion direction A are closed by the deep drawing of the ramp 30. The dimensions of the slot 31 roughly correspond to the cross-sectional dimensions of a chip card 20, the distance between the closed side edges 32 and 33 roughly corresponding to the width measurement of the chip card 20. The chip card 20 is guided in this manner by the side edges 32 and 33 in the insertion direction A in the area of the ramp 30.

According to an exemplary embodiment of this invention, not shown, the ramp 30 is formed by a section of sheet metal cut out of the upper housing part 13 along a U-shaped edge and bent inwards towards the printed circuit board 16. Consequently, the side edges are open. The slot for the passage of the chip card 20 into the inner space between the upper housing part 13 and printed circuit board 16 is provided in the same manner.

According to a further exemplary embodiment of this invention, not shown, parallel to the upper side 26 of the upper housing part 13, the opening unit 23 has a recess whose areas roughly correspond to the areas of the chip card 20. At its front end in the insertion direction A, this recess also has a corresponding access slot for the chip card.

In an extension of the side edges 32, 33, the guide unit 24 has in each case at least one, in the exemplary embodiment two, guide elements in the form of stamped-out lugs 36, 37 bent inwards approximately through a right-angle. The lugs 36, 37 are stamped out by cutting into the upper housing part 13, that is to say in such a way that they are bent away from each other, as shown in Figure 4. The previous outer and now inner faces of the lugs 36, 37 thus form limits, along which the longitudinal edges of the chip card 20 are guided in the insertion direction A. The holes 38, 39 formed by stamping out the lugs 36, 37 are covered by the inserted chip card 20.

In the insertion direction A it is necessary to limit the movement of the chip card 20 so that this rests in a definite manner on the contact-making arrangement 22. This can be achieved, for example, by an area of the continuous edge 41 of the upper housing part 13. In the exemplary embodiment as shown, an end stop 42 is provided, which is certainly also part of the upper housing part 13, but which is stamped out or cut out of the upper housing part 13 as a lug 43 and bent inwards. In the direction of the arrow A in the exemplary embodiment, the lug 43 is bent inwards from the upper housing part 13 approximately at a right-angle.

In accordance with the arrangement of the opening unit 23 and the end stop 42 on the upper housing part 13, provision is made for the chip card 20 to be inserted to a greater or lesser degree into the plug-in card 10, that is to say under the upper housing part 13 into its contact-making operational position. This means that, as shown in Figure 1, for example, the chip card 20 lies so far inside the opening unit 23 that it can be pushed out in the opposite direction to the arrow A by frictional contact between one of the user's fingers and the upper side of the chip card 20. If the chip card 20 is inserted much further into the plug-in card 10, then it is possible, for example, to lengthen one of the holes 38, 39, as shown by the broken line and denoted by 38' in Figure 1, so that the chip card 20 can be pushed out against the direction of the arrow A with the aid of a pencil or such like inserted into the hole 38, so that the chip card can be gripped in the above-mentioned manner and completely withdrawn.

According to an exemplary embodiment, not shown, the guide elements of the guide unit 24, and/or the end stop 42, are formed from metal or plastic elements attached or glued to the inside of the relevant housing part 13.

In the exemplary embodiment of this invention shown in the Figures 5 to 7, the upper housing part 113 is provided with an opening unit 123 in the same way as the upper housing part 13 shown in the Figures 1 to 4. In this exemplary embodiment, the design and position of the guide unit 124, which in this exemplary embodiment is formed by one or more components 46 to 49, that are already provided on the printed circuit board 116 as passive or active electronic components, differs from the above-mentioned exemplary embodiment. Naturally, in the illustrated exemplary embodiment, for the sake of clarity, only these components 46 to 49 are drawn on the printed circuit board 116, while, for the sake of clarity, the other components of the densely packed printed circuit board 116 are not shown. As shown by Figure 6, the components 46 to 49 are arranged around the contact-making arrangement 122 that is permanently connected to the printed circuit board 116. As shown by Figure 7, after it has been guided through the slot 31 of the opening unit 123, the chip card 20 is guided between the components 46 to 49. In this case the external shape of the components 46 to 49 plays a secondary role, it is merely important that they have an edge region that is designed to guide the chip card longitudinally. These components 46 to 49 can be formed, for example, by transistors, diodes, capacitors, resistors and the like, wherein they have an adequate height for the longitudinal guidance function assigned to them. A screening enclosure provided on the printed circuit board 116 can also function as such a component.

In this exemplary embodiment, an end stop 142 which likewise is formed by an active or passive electronic component 51 already present on the printed circuit board 116, is also provided.

Of course, the opening unit 123 provided in this exemplary embodiment as shown in Figures 5 to 7, can also be replaced by the opening units described, but not illustrated, in the first exemplary embodiment.

According to a further exemplary embodiment of this invention, not shown, the guide unit is formed by the combination of a part of the guide unit 24 according to the first exemplary embodiment or according to the exemplary embodiment described but not illustrated there, and a part of the guide unit 124 according to the second exemplary embodiment. For example, the chip card guide at the one longitudinal side if formed by lugs stamped out of the upper housing part 13 or by elements glued to the inside of the housing part, whereas the chip card guide on the other longitudinal side is formed by an active or passive electronic component, such as a screening enclosure for example, on the printed circuit board 116. It goes without saying that in this case different combinations of different numbers of stamped lugs, glued-on elements or components already in use, respectively, can be chosen.

## Claims

1. Plug-in card (10) for electronic equipment in an approximately elongated, rectangular, flat form, with a housing (11, 111) having an upper and a lower housing part (12, 13; 113) of substantially half-shell type construction, with a printed circuit board (16, 116) accommodated in the housing, on which printed circuit board a contact-making arrangement (23, 123) for a chip card (20), for example a SIM card, is electrically and mechanically retained, and with a receptacle for the chip card (20), **characterised in that** the chip card receptacle (21, 121) has an opening unit (23, 123) in the flat side of one of the two housing parts (13, 113) and in the direction of insertion of the chip card (20) has lateral guide elements (36, 37; 46-49) which are arranged on the inside of the same housing part (13, 113) and/or are formed by components of the printed circuit board (116).

2. Plug-in card according to Claim 1, **characterised in that** the opening unit (23) is formed by a recess formed in the relevant housing part (13, 113) and corresponding to the dimensions of the chip card (20), which recess has an access slot (31) on one side.

3. Plug-in card according to Claim 1, **characterised in that** the opening unit (23, 123) is formed by a ramp (30) directed towards the printed circuit board (16, 116), that delimits an access slot (31) at its free end.

4. Plug-in card according to Claim 2 or 3, **characterised in that** the recess and ramp (30), respectively, is formed in the relevant housing part (13, 113) by deep drawing.

5. Plug-in card according to Claim 3, **characterised in that** the ramp (130) is formed in the relevant housing part (113) by cutting and bending inwards.

6. Plug-in card according to at least one of Claims 3 to 5, **characterised in that** in the direction of insertion of the chip card (20) an opening slot (31, 131) delimited by the ramp has a cross-section corresponding approximately to the cross-section of the chip card.

7. Plug-in card according to at least one of Claims 1 to 6, **characterised in that** the lateral guide elements are formed on the relevant housing part (13) by lugs (36, 37) that are cut out and bent inwards.

8. Plug-in card according to one of Claims 1 to 6, **characterised in that** the lateral guide elements are formed on the relevant housing part (13) by metallic or plastic elements attached or glued to the inside of the housing part.

9. Plug-in card according to Claim 7 or 8, **characterised in that** lateral guide elements (36, 37) are provided on one or both sides.

10. Plug-in card according to Claim 7 or 9, **characterised in that** the lugs (36, 37) are bent in a direction facing away from the chip card (20).

11. Plug-in card according to at least one of Claims 1 to 6, **characterised in that** the lateral guide elements are formed on the printed circuit board (116) by passive or active electronic components (46-49).

12. Plug-in card according to at least one of the preceding Claims, **characterised in that** one of the lateral guide elements is formed by a screening enclosure.

13. Plug-in card according to at least one of,the preceding Claims, **characterised in that** an insertion end stop (42, 142) is provided.

14. Plug-in card according to Claim 13, **characterised in that** the insertion end stop (142) is formed on the relevant housing part (13) by a lug (43) that is cut out and bent inwards.

15. Plug-in card according to Claim 13, **characterised in that** the insertion end stop (142) is formed on the relevant housing part (13) by a metallic or plastic element attached or glued to the inside of the housing part.

16. Plug-in card according to Claim 13, **characterised in that** the insertion end stop (142) is formed on the printed circuit board (116) by a passive or active electrical component (51).

17. Plug-in card according to at least one of the preceding Claims, **characterised in that** the relevant housing part (13, 113) is provided with an extraction slot (38, 38') running in the direction of insertion.

## Patentansprüche

1. Steckkarte (10) für elektronische Geräte in etwa länglich rechteckförmiger flacher Form, mit einem ein oberes und ein unteres im wesentlichen halbschalenartig ausgebildetes Gehäuseteil (12, 13; 113) aufweisenden Gehäuse (11, 111) mit einer im Gehäuse aufgenommenen Leiterplatte (16, 116), auf der eine Kontaktiereinrichtung (23, 123) für eine Chipkarte (20), wie beispielsweise SIM-Karte, elektrisch und mechanisch gehalten ist, und mit einer Aufnahme für die Chipkarte (20), **dadurch gekennzeichnet, daß** die Chipkartenaufnahme (21, 121) eine Öffnungseinheit (23, 123) in der flächigen Seite eines der beiden Gehäuseteile (13, 113) und in Einschubrichtung der Chipkarte (20) seitliche Führungselemente (36, 37; 46-49) aufweist, die innenseitig am selben Gehäuseteil (13, 113) angeordnet und/oder durch Bauteile der Leiterplatte (116) gebildet sind.

2. Steckkarte nach Anspruch 1, **dadurch gekennzeichnet, daß** die Öffnungseinheit (23) durch eine im betreffenden Gehäuseteil (13, 113) eingeformte und den Abmessungen der Chipkarte (20) entsprechende Vertiefung, die an einer Seite einen Zugangsschlitz (31) aufweist, gebildet ist.

3. Steckkarte nach Anspruch 1, **dadurch gekennzeichnet, daß** die Öffnungseinheit (23, 123) durch eine zur Leiterplatte (16, 116) hinweisende Rampe (30), die an ihrem freien Ende einen Zugangsschlitz (31) begrenzt, gebildet ist.

4. Steckkarte nach Anspruch 2 oder 3, **dadurch gekennzeichnet, daß** die Vertiefung beziehungsweise Rampe (30) im betreffenden Gehäuseteil (13, 113) durch Tiefziehen gebildet ist.

5. Steckkarte nach Anspruch 3, **dadurch gekennzeichnet, daß** die Rampe (130) im betreffenden Gehäuseteil (113) durch Einschneiden und nach innen biegen gebildet ist.

6. Steckkarte nach mindestens einem der Ansprüche 3 bis 5, **dadurch gekennzeichnet, daß** ein durch die Rampe begrenzter Öffnungsschlitz (31, 131) in Einschubrichtung der Chipkarte (20) einen dem Querschnitt der Chipkarte etwa entsprechenden Querschnitt aufweist.

7. Steckkarte nach mindestens einem der Ansprüche 1 bis 6, **dadurch gekennzeichnet, daß** die seitlichen Führungselemente am betreffenden Gehäuseteil (13) durch eingeschnittene und nach innen gebogene Lappen (36, 37) gebildet sind.

8. Steckkarte nach mindestens einem der Ansprüche 1 bis 6, **dadurch gekennzeichnet, daß** die seitlichen Führungselemente am betreffenden Gehäuseteil (13) durch an der Gehäuseteilinnenseite befestigte, bspw. geklebte Metall- oder Kunststoffelemente gebildet sind.

9. Steckkarte nach Anspruch 7 oder 8, **dadurch gekennzeichnet, daß** an einer oder beiden Seiten seitliche Führungselemente (36, 37) vorgesehen sind.

10. Steckkarte nach Anspruch 7 oder 9, **dadurch gekennzeichnet, daß** die Lappen (35, 37) in eine von der Chipkarte (20) wegweisende Richtung umgebogen sind.

11. Steckkarte nach mindestens einem der Ansprüche 1 bis 6, **dadurch gekennzeichnet, daß** die seitlichen Führungselemente an der Leiterplatte (116) durch inaktive oder aktive elektronische Bauteile (46-49) gebildet sind.

12. Steckkarte nach mindestens einem der vorhergehenden Ansprüche, **dadurch gekennzeichnet, daß** eines der seitlichen Führungselemente durch ein Abschirmungsgehäuse gebildet ist.

13. Steckkarte nach mindestens einem der vorhergehenden Ansprüche, **dadurch gekennzeichnet, daß** ein Einschubbegrenzungsanschlag (42, 142) vorgesehen ist.

14. Steckkarte nach Anspruch 13, **dadurch gekennzeichnet, daß** der Einschubbegrenzungsanschlag (142) am betreffenden Gehäuseteil (13) durch einen eingeschnittenen, nach innen gebogenen Lappen (43) gebildet ist.

15. Steckkarte nach Anspruch 13, **dadurch gekennzeichnet, daß** der Einschubbegrenzungsanschlag (142) am betreffenden Gehäuseteil (13) durch ein an der Gehäuseteilinnenseite befestigtes, bspw. geklebtes Metall- oder Kunststoffelement gebildet ist.

16. Steckkarte nach Anspruch 13, **dadurch gekennzeichnet, daß** der Einschubbegrenzungsanschlag (142) durch ein inaktives oder aktives elektrisches Bauteil (51) auf der Leiterplatte (116) gebildet ist.

17. Steckkarte nach mindestens einem der vorhergehenden Ansprüche, **dadurch gekennzeichnet, daß** das betreffende Gehäuseteil (13, 113) mit einem in Einschubrichtung verlaufenden Ausschubschlitz (38, 38') versehen ist.

## Revendications

1. Carte enfichable (10) pour équipement électronique, sous forme approximativement plane, rectangulaire et allongée, comprenant un boîtier (11, 111) ayant une partie de boîtier supérieure et une partie de boîtier inférieure (12, 13 ; 113) avec une structure sensiblement du type demi-coque, comprenant une carte à circuits imprimés (16, 116) logée dans le boîtier et sur laquelle un agencement de mise en contact (23, 123) pour une carte à puce (20) comme par exemple une carte SIM est retenu électriquernent et mécaniquement sur ladite carte à circuits imprimés, et comportant un réceptacle pour la carte à puce (20), **caractérisée en ce que** le réceptacle pour carte à puce (21, 121) comprend une unité d'ouverture (23, 123) dans le côté plat de l'une des deux parties de boîtier (13, 113), et comporte dans la direction d'introduction de la carte à puce (20) des éléments de guidage latéraux (36, 37 ; 46-49) qui sont agencés sur l'intérieur de la même partie de boîtier (13, 113) et/ou qui sont formés par des composants de la carte à circuits imprimés (116).

2. Carte enfichable selon la revendication 1, **caractérisée en ce que** l'unité d'ouverture (23) est formée par un évidement formé dans la partie de boîtier concernée (13, 113) et correspondant aux dimensions de la carte à puce (20), ledit évidement comportant une fente d'accès (31) sur un côté.

3. Carte enfichable selon la revendication 1, **caractérisée en ce que** l'unité d'ouverture (23, 123) est formée par une rampe (30) dirigée vers la carte à circuits imprimés (16, 116), qui délimite une fente d'accès (31) à son extrémité libre.

4. Carte enfichable selon l'une ou l'autre des revendications 2 et 3, **caractérisée en ce que** l'évidement et la rampe (30), respectivement, sont formés dans la partie de boîtier concernée (13, 113) par emboutissage profond.

5. Carte enfichable selon la revendication 3, **caractérisée en ce que** la rampe (130) est formée dans la partie de boîtier concernée (113) par découpe et par cintrage vers l'intérieur.

6. Carte enfichable selon l'une au moins des revendications 3 à 5, **caractérisée en ce que**, dans la direction d'introduction de la carte à puce (20), une fente d'ouverture (31, 131) délimitée par la rampe a une section transversale correspondant approximativement à la section transversale de la carte à puce.

7. Carte enfichable selon l'une au moins des revendications 1 à 6, **caractérisée en ce que** les éléments de guidage latéraux sont formés sur la partie de boîtier concernée (13) par des pattes (36, 37) qui sont découpées et recourbées vers l'intérieur.

8. Carte enfichable selon l'une des revendications 1 à 6, **caractérisée en ce que** les éléments de guidage latéraux sont formés sur la partie de boîtier concernée (13) par des éléments métalliques ou en matière plastique attachés ou collés sur l'intérieur de la partie de boîtier.

9. Carte enfiche selon l'une ou l'autre des revendications 7 et 8, **caractérisée en ce que** les éléments de guidage latéraux (36, 37) sont prévus sur un côté ou sur les deux côtés.

10. Carte enfichable selon l'une ou l'autre des revendications 7 et 9, **caractérisée en ce que** les pattes (36, 37) sont recourbées dans une direction détournée de la carte à puce (20).

11. Carte enfichable selon l'une au moins des revendications 1 à 6, **caractérisée en ce que** les éléments de guidage latéraux sont formés sur la carte à circuits imprimés (116) par des composants électroniques passifs ou actifs (46-49).

12. Carte enfichable selon l'une au moins des revendications précédentes, **caractérisée en ce que** l'un des éléments de guidage latéraux est formé par une enceinte-écran.

13. Carte enfichable selon l'une au moins des revendications précédentes, **caractérisée en ce qu'**il est prévu un arrêt de fin d'introduction (42, 142).

14. Carte enfichable selon la revendication 13, **caractérisée en ce que** l'arrêt de fin d'introduction (142) est formé sur la partie de boîtier concernée (13) par une patte (43) qui est découpée et recourbée vers l'intérieur.

15. Carte enfichable selon la revendication 13, **caractérisée en ce que** l'arrêt de fin d'introduction (142) est formé sur la partie de boîtier concernée (13) par un élément métallique ou en matière plastique attaché ou collé sur l'intérieur de la partie de boîtier.

16. Carte enfichable selon la revendication 13, **caractérisée en ce que** l'arrêt de fin d'introduction (142) est formé sur la carte à circuits imprimés (116) par un composant électrique passif ou actif (51).

17. Carte enfichable selon l'une au moins des revendications précédentes, **caractérisée en ce que** la partie de boîtier concernée (13, 113) est pourvue d'une fente d'extraction (38, 38') qui s'étend dans la direction d'introduction.
